# EUROPEAN PATENT APPLICATION

(11) **EP 2 722 982 A1**
(43) Date of publication of application: **23.04.2014**
(21) Application number: 12290348.7
(22) Date of filing: 16.10.2012
(51) Int. Cl.: H03F 3/193, H03F 3/24

(54) **Amplifier circuits**

(71) Applicant: NXP B.V., 5656 AG Eindhoven (NL)
(72) Inventor: Bouisse, Gerard, Redhill Surrey RH1 1NY (GB)

(57) **Abstract**

Radio Frequency (RF) amplifier circuits are disclosed which may exhibit improved video/instantaneous bandwidth performance compared to conventional circuits. For example, disclosed RF amplifier circuits may employ first and second baseband decoupling networks. The first baseband decoupling network may be connected between an RF input terminal of the amplifier circuit and a control terminal of the transistor; and the second baseband decoupling network may be connected between a DC input terminal of the amplifier circuit and the control terminal of the transistor.

## Description

This invention relates to the field of amplifier circuits, and more particularly to radio frequency power amplifier circuits.

Power amplifier circuits are widely used in Radio Frequency (RF) applications. The video bandwidth, or instantaneous bandwidth, of a RF power amplifier represents the ability of the RF power amplifier to instantaneously amplify a linear signal (i.e. a signal with a variable envelope) without asymmetrical distortion.

Thus, the instantaneous bandwidth represents the broadest modulating signal that can be handled instantaneously by a RF power amplifier without asymmetrical distortion.

Asymmetry in signal distortion is generally unacceptable because it is difficult to correct.

For mobile communication applications, signal modulations have become increasingly wideband over the past years (from 200kHz to 75MHz today and >100MHz in the future) so as to achieve higher data rates. Video bandwidth is therefore of growing importance and typically a discriminating factor in the field of amplification for mobile communication applications.

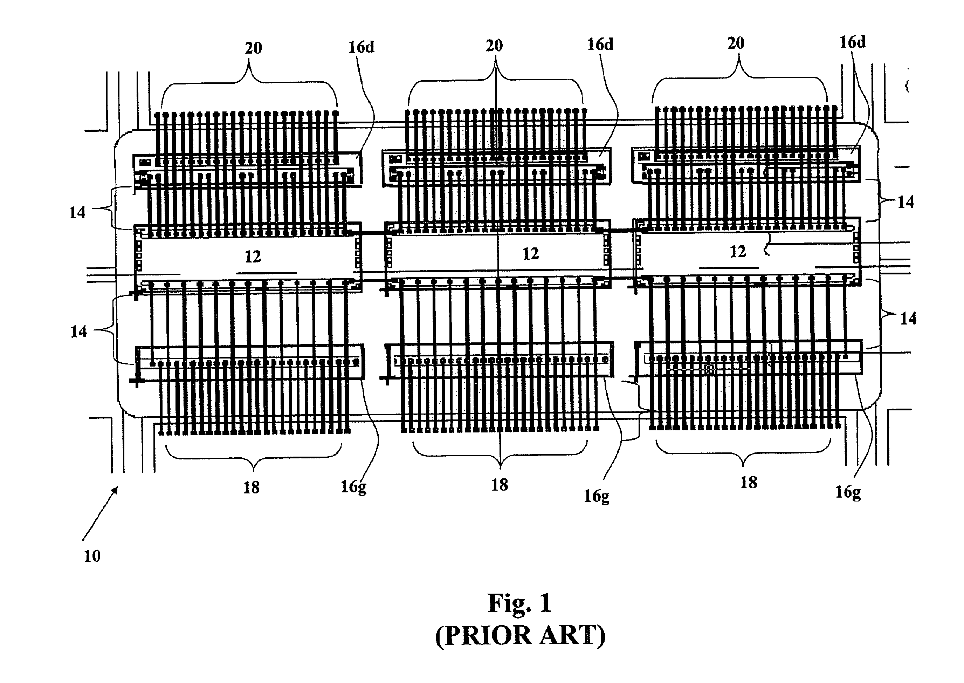

Figure 1 is a schematic diagram of a conventional discrete (i.e. packaged) RF-LDMOS power amplifier 10. The amplifying transistors are located on silicon dies 12 provided within the package. The package 10 further includes a matching network consisting of bond wires 14 and discrete capacitors 16. Gate input leads 18 are connected to the transistor gates via gate-side capacitors 16g and drain output leads 20 are connected to the transistor drains via drain-side capacitors 16d.

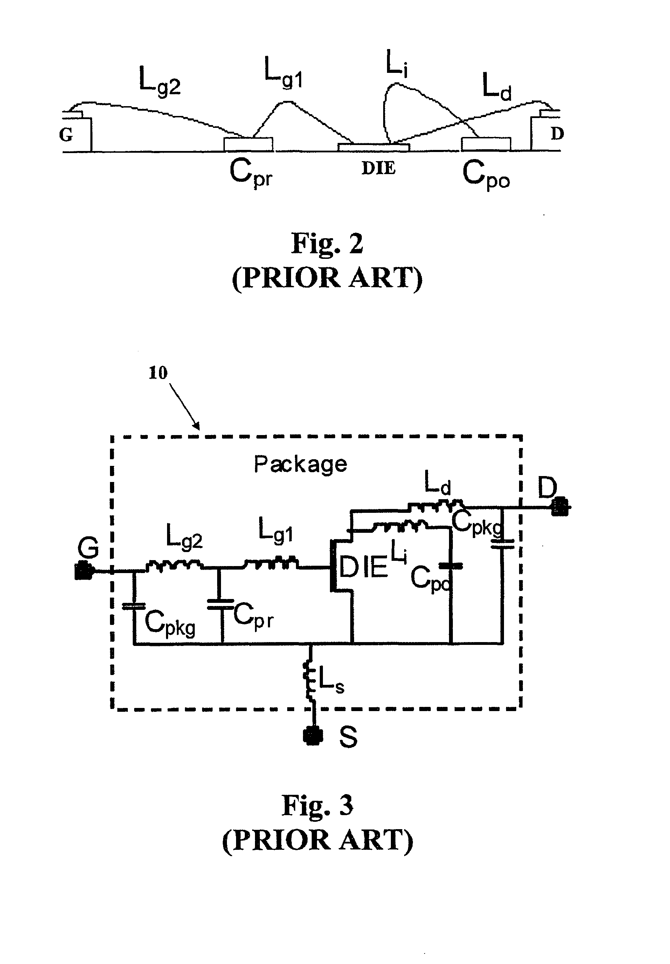

Turning to Figure 2, there is illustrated a set of bond-wire connections between capacitors and a die of the device of Figure 1. The bond-wire connection between the gate-side capacitor 16g (Cpr) and the gate terminal G of the package has an inductance denoted Lg2, and the bond-wire connection between the gate-side capacitor 16g (Cpr) and the gate of the transistor on the die (DIE) has an inductance denoted Lg1. Similarly, the bond-wire connection between the drain of the transistor on the die (DIE) and the drain terminal D of the package has an inductance denoted Ld, and the bond-wire connection between the drain-side capacitor 16d (Cpo) and the drain of the transistor on the die (DIE) has an inductance denoted Li. An equivalent circuit diagram of the device of Figure 1 illustrating the relative connections of the capacitances and inductances is provided in Figure 3. From this, it will be seen that a capacitance Cpkg is present at each of the gate and drain terminals of the package (connected in parallel with the other capacitances), and that a source inductance Ls is associated with the source terminal of the package 10.

The conventional implementation described above leads to insufficient results in terms of video bandwidth (VBW) performance, signal distortion, and linearity degradation, and ultimately may not meet the minimum requirements imposed by modern telecommunications standards.

Proposed are concepts for improving VBW performance of a RF amplifier circuit.

According to an aspect of the invention there is provided a radio frequency amplifier circuit according to an independent claim.

Embodiments may relate to improving video bandwidth performance in the input side of a RF amplifying circuit.

Other embodiments may employ first and second decoupling networks in the RF amplifying circuit. The first decoupling network may be connected between an RF input terminal of the amplifier circuit and a control terminal of the transistor; and the second baseband decoupling network may be connected between a DC input terminal of the amplifier circuit and the control terminal of the transistor.

The second decoupling network may comprise a damping resistance; and a baseband decoupling capacitance.

Thus, embodiments may employ additional (with respect to any feeding/decoupling that may be provided outside of a conventional packaged amplifier circuit) baseband decoupling on the gate side.

Examples of the invention will now be described in detail with reference to the accompanying drawings, in which:
Figure 1 is a schematic diagram of a conventional discrete (i.e. packaged) RF amplifier circuit;
Figure 2 illustrates a set of bond-wire connections between capacitors and a die of the device of Figure 1;
Figure 3 is an equivalent circuit diagram of the device of Figure 1 illustrating the relative connections of the capacitances and inductances;
Figure 4 is an electrical representation of a conventional output matching structure as it is used in an RF simulator;
Figure 5 shows the gate plane portion of a circuit board configuration of a conventional RF amplifier circuit;
Figure 6A illustrates a simulated variation of the magnitude of baseband impedance with operating frequency for the conventional circuit board configuration of Figure 5, wherein the damping resistor is zero (0) ohms;
Figure 6B illustrates a simulated variation of the magnitude of baseband impedance with operating frequency for the conventional circuit board configuration of Figure 5, wherein the damping resistor is 4.7 ohms;
Figure 7 is a schematic diagram of discrete RF amplifier circuit according to an embodiment of the invention;
Figure 8 illustrates a gate portion of a circuit board configuration of the RF amplifier circuit of Figure 7;
Figure 9A illustrates a simulated variation of the magnitude of baseband impedance with operating frequency for the circuit board configuration of Figure 8, wherein the damping resistors are zero ohms; and
Figure 9B illustrates a simulated variation of the magnitude of baseband impedance with operating frequency for the circuit board configuration of Figure 8, wherein the damping resistors are 2.2 ohms.

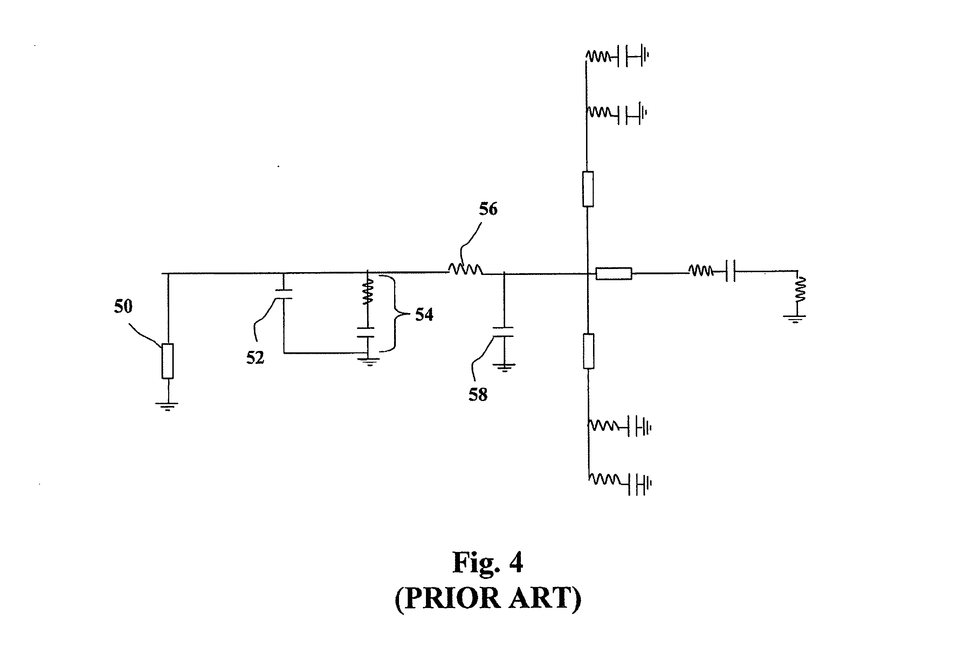

Figure 4 is an electrical representation of a conventional output matching structure as it is used in an RF simulator.

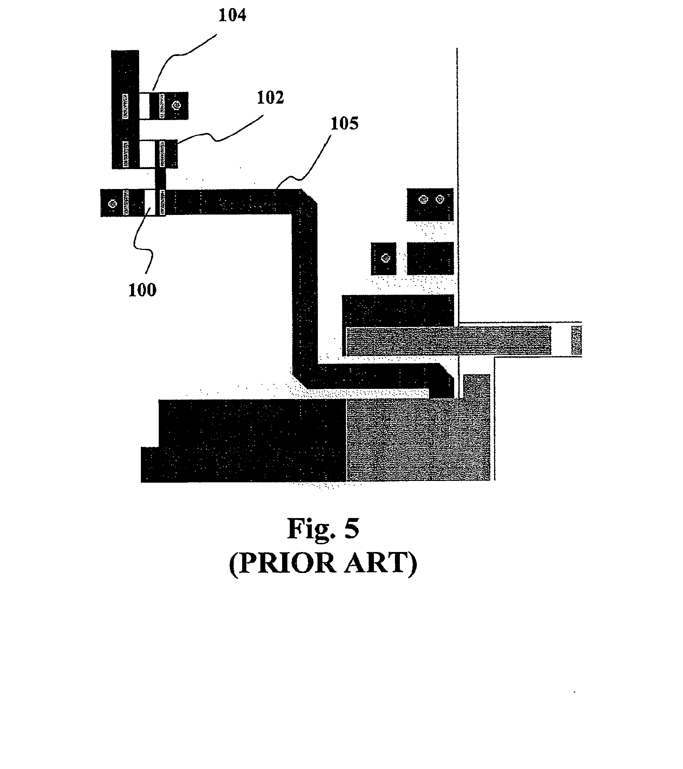

From left to right, the extreme left element 50 is a port, and represents the current source of the device (this is the reference plane for the impedance simulations from Figure 5A and 5B) The shunt capacitance 52 on its right, represents Cds, the shunt capacitance drain to source from the FET. Then the next three elements are matching elements inside the package (the series LC network 54 to ground, and the series inductance 56). The next shunt capacitance 58, represents the package lead.

On the right side of the lead, is represented the output matching network, to 50 ohms, on the PCB, and the connection to the power supply, through a quarter wave element, and RF and baseband decoupling shunt capacitors.

Thus, in other words, Figure 4 represents an electrical circuit, as used in a simulator, describing the typical passive elements from the current source of an active device to 50 ohms, through internal and external (to the package) matching elements, as well as connection to the DC power supply.

Figure 5A is a graph illustrating a variation of the magnitude of baseband impedance with operating frequency for the RF amplifier circuit of Figure 4. Figure 5B is a graph illustrating a variation of the phase of baseband impedance with operating frequency for the conventional RF amplifier circuit of Figure 4. Figures 5A and 5B thus illustrate the frequency response of the conventional RF amplifier circuit of Figure 4.

A limitation to the video bandwidth resides in the baseband termination presented to the amplifying device (e.g. the transistor) in its gate and drain plane. The gate plane will thus now be considered.

Figure 5 shows the gate plane portion of a circuit board configuration of a conventional RF amplifier circuit.

The feeding/decoupling is done on the application board only. It employs a RF decoupling cap 100, a damping resistor 102, and a baseband decoupling capacitor 104). In other words, a baseband decoupling network is connected between the gate I/P terminal of the circuit and the gate and ground. The gate I/P terminal (otherwise referred to as the gate lead) is connected to the gate of the amplifying transistor via an input network and a quarter (1/4) wave feed element 105.

Fig. 5 therefore illustrates a conventional feeding and biasing arrangement at the gate side of a high-power transistor. DC biasing is fed through to the gate using the quarter wave feed element 105.

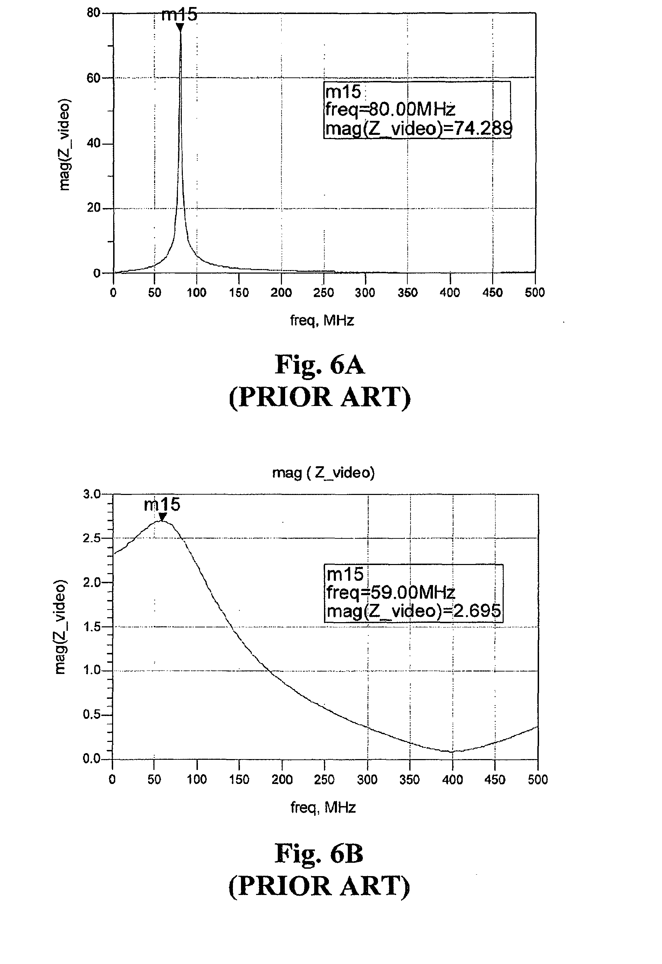

In Figure 6A, there is illustrated a simulated variation of the magnitude of baseband impedance with operating frequency for the conventional circuit board configuration of Figure 5, wherein the damping resistor 102 is 0 ohms (i.e. the circuit board configuration has no damping). Due to all the RF and baseband passive elements, a resonance appears at 80MHz and its magnitude is 74 ohms. This resonance is too low in frequency to meet modern bit rate requirements, and would lead to an 80 MHz oscillation because of its excessive amplitude.

Turning to Figure 6B, there is illustrated a simulated variation of the magnitude of baseband impedance with operating frequency for the conventional circuit board configuration of Figure 5, wherein the damping resistor 102 is 4.7 ohms (i.e. the circuit board configuration has damping). Compared to the simulation results shown in Figure 6A, the resonance is greatly reduced (to a maximum magnitude of 2.695 ohms) due to the damping resistor 102. The resonance damping (i.e. the damping resistance) defines the magnitude of the baseband impedance in the gate plane. This impedance will lead to currents equal to the residual envelope voltage/residual impedance, and this will set the linearisation floor.

It will be appreciated that due to the presence of RF and baseband passive elements around the transistor, a parallel resonance appears on the gate of the transistor. This creates design considerations, including:
- The resonant frequency is a hard limit in terms of bit rate, and so preferably it needs to be increased.
- Presence of the resonant frequency leads to an oscillation (at the resonant frequency), so it should preferably damped so as to be lowered in magnitude.
- Resonance damping should preferably be controlled because it is responsible for memory effects, and limits the mandatory linearisation, in terms of floor level.

Embodiments are proposed to increase the resonance frequency and lower the necessary damping, therefore improving the linearisation floor. In particular, embodiments employ supplementary baseband decoupling on the gate side through DC leads of a RF amplifier circuit package. Such supplementary baseband decoupling is in addition to already existing decoupling that is provided outside of conventional PCB packages.

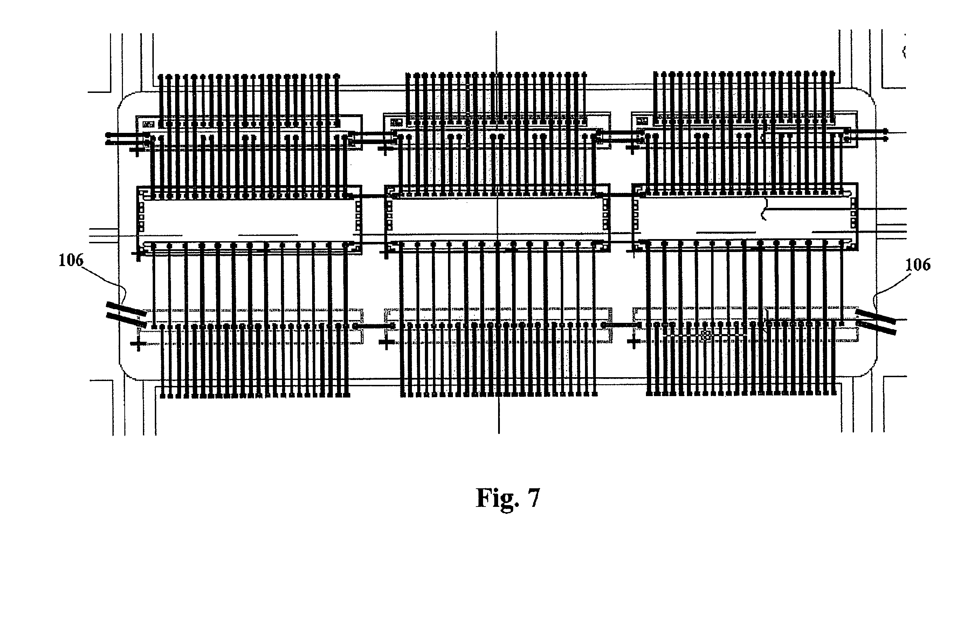

Figure 7 is a schematic diagram of discrete (i.e. packaged) RF-LDMOS power amplifier circuit according to an embodiment of the invention

It will be appreciated that the embodiment of Figure 7 comprises extra wirebond connections 106 between the gate of the transistor and the DC leads.

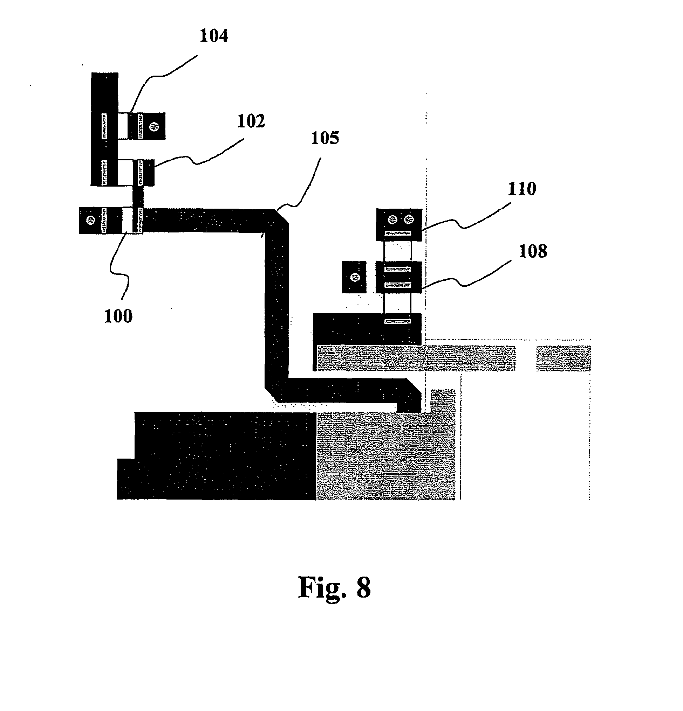

Turning to Figure 8, there is shown a gate portion of a circuit board configuration of the RF amplifier circuit of Figure 7. Similarly to the conventional arrangement shown in Figure 5, the embodiment shown in Figure 8 employs a RF decoupling cap 100, a damping resistor 102, and a baseband decoupling capacitor 104). However, it employs a double feeding/decoupling structure in that it uses the DC leads to provide additional baseband decoupling and damping resistance. In particular, a second baseband decoupling capacitor 108 and a second damping resistor 110 is connected to the DC leads.

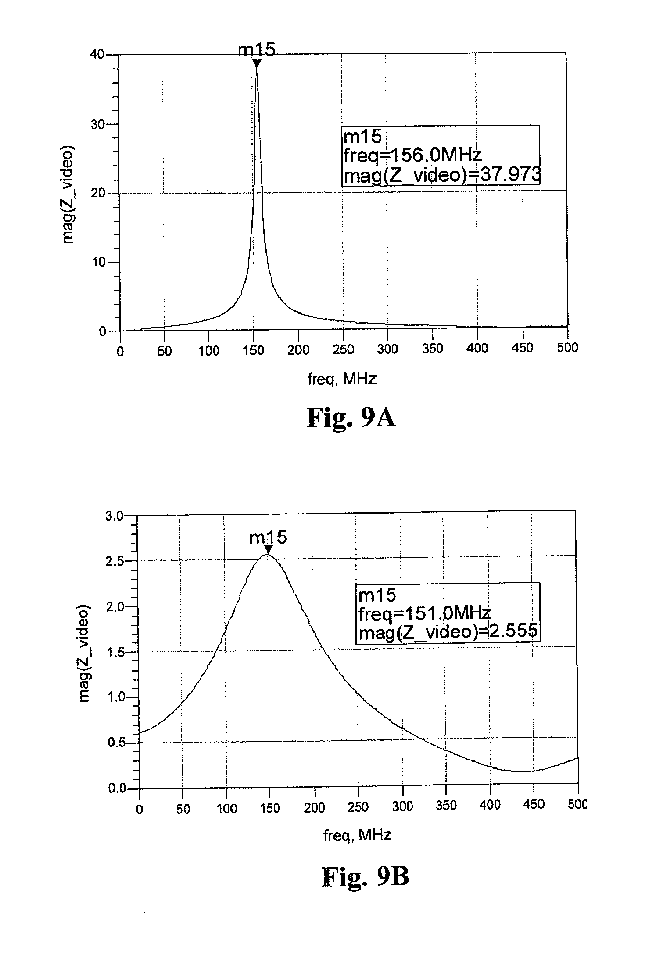

Referring to Figure 9A, there is illustrated a simulated variation of the magnitude of baseband impedance with operating frequency for the circuit board configuration of Figure 8, wherein the damping resistors 102 and 110 ares 0 ohms (i.e. the circuit board configuration has no damping). The resonance is approximately two times higher in frequency than the conventional circuit configuration of Figure 15 and is lower magnitude. This is due to the reduction in inductance between the gate and the base band decoupling. The damping (i.e. reduction of the maximum magnitude) is caused by the natural Q decrease with frequency.

Next, in Figure 9B, there is illustrated a simulated variation of the magnitude of baseband impedance with operating frequency for the circuit board configuration of Figure 8, wherein the damping resistors 102 and 110 are 2.2 ohms (i.e. the circuit board configuration has damping). The resonant frequency remains (higher than that of the conventional configuration) at 151 MHz and is now damped by resistors 102 and 110. Due to the parallel arrangement of the damping resistors, the residual resistance is four times lower than in the conventional case, which in turn leads to four times less memory effect currents. This improves the linearisation floor.

Embodiments may employ a concept of reducing the electrical distance (and thus the inductance) between a baseband decoupling capacitance (which is conventionally external to a RF amplifying circuit package) and gate of the amplifying device. This defines the baseband termination resonance presented to the gate of the device (which contributes to video bandwidth limitation). Embodiments also reduce the required damping, which is responsible for memory effects and limits the linearisation floor of the system.

Embodiments may thus provide RF amplifier circuit arrangements having improved video bandwidth and/or signal distortion performance.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A radio frequency, RF, amplifier circuit comprising:
a transistor arranged to amplify a signal;
a first baseband decoupling network connected between an RF input terminal of the amplifier circuit and a control terminal of the transistor or ground; and
a second baseband decoupling network connected between a DC input terminal of the amplifier circuit and the control terminal of the transistor or ground.

2. The circuit of claim 1, wherein the first baseband decoupling network comprises: a first RF decoupling capacitance; a first damping resistance; and a first baseband decoupling capacitance,
and wherein the second baseband decoupling network comprises: a second damping resistance; and a second baseband decoupling capacitance.

3. The circuit of claim 2, wherein the first baseband decoupling network further comprises a quarter-wave element.

4. A packaged circuit comprising an RF amplifier circuit according to any preceding claim

5. An integrated circuit comprising a RF amplifier circuit according to any of claims 1 to 3

6. A mobile base station comprising a RF amplifier circuit according to any of claims 1 to 3.
